# EUROPEAN PATENT APPLICATION

(11) **EP 2 325 899 A1**
(43) Date of publication of application: **25.05.2011**
(21) Application number: 09810080.3
(22) Date of filing: 31.08.2009
(51) Int. Cl.: H01L 33/00

(54) **SEMICONDUCTOR DEVICE**

(30) Priority: 29.08.2008 JP 2008221471
(71) Applicant: Kabushiki Kaisha Toshiba, Minato-ku Tokyo 105-8001 (JP)
(72) Inventor: NAGO, Hajime, Minato-ku Tokyo 105-8001 (JP); TACHIBANA, Koichi, Minato-ku Tokyo 105-8001 (JP); SAITO, Shinji, Tokyo 105-8001 (JP); HARADA, Yoshiyuki, Minato-ku Tokyo 105-8001 (JP); NUNOUE, Shinya, Minato-ku Tokyo 105-8001 (JP)
(74) Representative: HOFFMANN EITLE
(86) International application number: PCT/JP2009/065195
(87) International publication number: WO 2010/024436

(57) **Abstract**

There is provided a semiconductor device including an underlying layer (20), and a light emitting layer (30) which is formed on the underlying layer (20) and in which a barrier layer made of InAlGaN and a quantum well layer made of InGaN are alternately stacked.

## Description

### Technical Field

The present invention relates to a semiconductor device.

### Background Art

In recent years, the research and development on light emitting diode (LED) using InGaN based semiconductor is being progressed (see Patent Document 1). However, the light emitting diode using InGaN based semiconductor has a problem that it is difficult to obtain a green color with high light emitting efficiency and high luminance.

### Citation List

### Patent Document

Patent Document 1: JP-A 2002-43618 (KOKAI) Summary of Invention

### Technical Problem

The present invention aims to provide a semiconductor device capable of obtaining a light emitting diode with high light emitting efficiency.

### Solution to Problem

A semiconductor device according to an aspect of the present invention comprises an underlying layer; and a light emitting layer which is formed on the underlying layer and in which a barrier layer made of InAlGaN and a quantum well layer made of InGaN are alternately stacked.

### Advantageous Effects of Invention

According to the present invention, it is possible to provide a semiconductor device capable of obtaining a light emitting diode with high light emitting efficiency.

### Brief Description of Drawings

FIG. 1 is a cross sectional view schematically showing a basic structure of a semiconductor device according to a first embodiment;
FIG. 2 is a cross sectional view schematically showing a detailed structure of a light emitting layer according to the first embodiment;
FIG. 3 is a diagram showing a relationship between a lattice constant and a bandgap;
FIG. 4 is a diagram showing a measurement result of the semiconductor device according to the first embodiment;
FIG. 5 is a diagram showing a measurement result of a semiconductor device according to a first comparative example of the first embodiment;
FIG. 6 is a diagram showing a measurement result of a semiconductor device according to a second comparative example of the first embodiment; and
FIG. 7 is a cross sectional view schematically showing a structure of a semiconductor device according to a second embodiment.

### Description of Embodiments

The embodiments according to the present invention will be described below with reference to the drawing.

### (First embodiment)

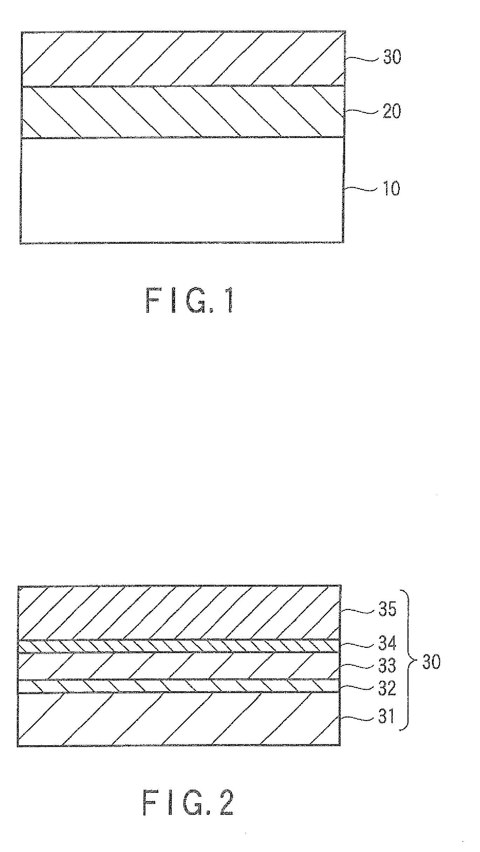

FIG. 1 is cross sectional view schematically showing a basic structure of a semiconductor device (light emitting diode) according to a first embodiment of the present invention. The semiconductor device shown in FIG. 1 is configured with a substrate 10, an underlying layer 20 formed on the substrate 10, and a light emitting layer 30 formed on the underlying layer 20.

A sapphire substrate is employed for the substrate 10 and the upper surface (device forming surface) of the sapphire substrate 10 is the (0001) surface of sapphire crystal, that is, C surface. A GaN layer as the underlying layer 20 is formed on the upper surface (C surface) of the sapphire substrate 10. The light emitting layer 30 having a multi quantum well structure is formed on the GaN layer 20.

FIG. 2 is a cross sectional view schematically showing a detailed structure of the light emitting layer 30 shown in FIG. 1. FIG. 2 shows only one cycle of the light emitting layer 30 for convenience, but the light emitting layer 30 shown in FIG. 2 is actually stacked in two or more cycles. As shown in FIG. 2, the light emitting layer 30 is configured in a stack structure made of a barrier layer 31, an intermediate layer 32, a quantum well layer 33, an intermediate layer 34 and a barrier layer 35.

The barrier layer 31 is made of InAlGaN (generally expressed as InₓAl_{y}Ga_{1-x-y}N (0<x<1, 0<y<1)) and has a thickness of 12.5 nm. Specifically, the barrier layer 31 is made of In_{0.02}Al_{0.33}Ga_{0.65}N.

The intermediate layer 32 is made of InGaN (generally expressed as InₓGa₁₋ₓN (0<x<1)) and has a thickness of 0.5 nm. Specifically, the intermediate layer 32 is made of In_{0.02}Ga_{0.98}N.

The quantum well layer 33 is made of InGaN (generally expressed as InₓGa₁₋ₓN (0<x<1)) and has a thickness of 2.5 nm. Specifically, the quantum well layer 33 is made of In_{0.15}Ga_{0.85}N.

The intermediate layer 34 is made of InGaN (generally expressed as InₓGa₁₋ₓN (0<x<1)) and has a thickness of 0.5 nm. Specifically, the intermediate layer 34 is made of In_{0.02}Ga_{0.98}N.

The barrier layer 35 is made of InAlGaN (generally expressed as InₓAl_{y}Ga_{1-x-y}N (0<x<1, 0<y<1)) and has a thickness of 11.5 nm. Specifically, the barrier layer 35 is made of In_{0.02}Al_{0.33}Ga_{0.65}N.

In the present embodiment, the stack structure in FIG. 2 is formed for 5 cycles. Then, an InAlGaN (generally expressed as InₓAl_{y}Ga_{1-x-y}N (0<x<1, 0<y<1)) layer having a thickness of 15 nm is formed as a cap layer at the uppermost layer. Specifically, the cap layer is made of In_{0.02}Al_{0.33}Ga_{0.65}N.

The aforementioned structure is formed by epitaxial growth of the underlying layer 20 and the light emitting layer 30 on the (0001) surface (that is, C surface) of the sapphire substrate 10. Specifically, a metal organic chemical vapor deposition (MOCVD) method, molecular beam epitaxy (MBE) method or the like can be employed for the epitaxial growth method.

The semiconductor device according to the present embodiment described above can obtain a light emitting diode with high light emitting efficiency and high luminance. The reasons therefor will be described below.

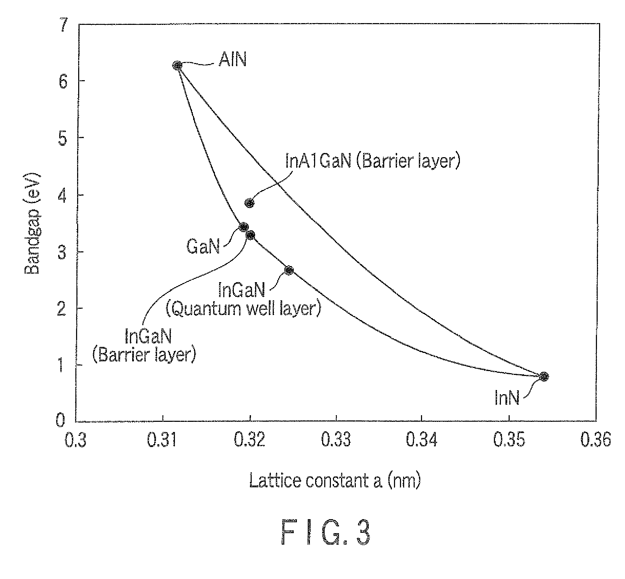

FIG. 3 is a diagram showing a relationship between a lattice constant and a bandgap in a compound semiconductor. As can be seen from FIG. 3, the lattice constant is larger in InGaN than in GaN, and the lattice constant of InGaN increases as an In composition of InGaN increases. Therefore, when the InGaN layer having a high In composition is grown on the GaN layer as in the quantum well layer, a compressive strain occurs in the planar direction (a-axis direction) and a tensile strain occurs in the growth direction (c-axis direction). In this case, the InGaN layer having a low In composition or the InAlGaN layer having a low In composition is provided as the barrier layer, thereby alleviating the compressive strain in the planar direction (a-axis direction).

However, when the InGaN layer having a low In composition is employed as the barrier layer, the tensile strain in the growth direction (c-axis direction) cannot be largely alleviated. When the tensile strain in the c-axis direction is large, a piezoelectric field due to piezoelectric polarization is made larger. Thus, a possibility of recombination between electron and hole is lowered and the light emitting efficiency is lowered. The piezoelectric field due to the tensile strain in the c-axis direction increases along with an increase in In composition. Further, when the piezoelectric field is large, the injected current density dependency of the quantum efficiency shows that the decrease of the quantum efficiency in a high injected current density region is remarkable, and it is not suitable for a light emitting diode used at the high injected current density. Thus, when the In composition of the quantum well layer is increased, the light emitting efficiency is lowered. On the other hand, as can be seen from FIG. 3, the In composition of the quantum well layer needs to be increased for elongating a light emitting wavelength (for reducing a bandgap). From the above, when the InGaN layer having a low In composition is employed as the barrier layer, it is difficult to elongate the light emitting wavelength without largely reducing the light emitting efficiency.

On the contrary, when the InAlGaN layer having a low In composition is employed as the barrier layer, the tensile strain in the growth direction (c-axis direction) can be largely alleviated. Thus, even if the In composition of the quantum well layer is increased for elongating the light emitting wavelength, a remarkable decrease in light emitting efficiency can be restricted. Therefore, as in the present embodiment, the InAlGaN layer is employed as the barrier layer, thereby elongating the light emitting wavelength without largely reducing the light emitting efficiency. Since the piezoelectric field can be reduced in the present embodiment, it is possible to prevent the decrease of the quantum efficiency in a high injected current density region, and the light emitting diode with high injected current density and high efficiency can be provided. In addition, using InAlGaN as a barrier layer enables band gap energy of the barrier layer to increase, and overflow of carriers, particularly electrons, can be prevented. Thus, it is suitable for the light emitting diode used at the high injected current density. For example, it is possible to obtain a high power light emitting diode having current density of 100 A/cm² or more.

According to the experimental result by the present inventors, it was confirmed that even when the In composition of the quantum well layer is the same, the light emitting wavelength can be elongated more when the InAlGaN layer is employed as the barrier layer than when the InGaN layer is employed as the barrier layer. Also from this viewpoint, in the present embodiment, the light emitting wavelength can be elongated without largely reducing the light emitting efficiency. That is, when the light emitting diode having the same light emitting wavelength is manufactured, the In composition of the quantum well layer can be reduced in this embodiment. The description thereof will be made below. Originally, if the In composition of the InGaN quantum well layer is the same, the light emitting wavelength should not change. Nevertheless, the InAlGaN layer is employed as the barrier layer so that the light emitting wavelength can be elongate, which may be based on the following reasons. As can be seen from FIG. 3, a difference in bandgap and a difference in lattice constant between AlN and InN are larger than those between GaN and InN. Thus, when the InAlGaN layer is employed as the barrier layer, a thermodynamic composition variation easily occurs. Thus, it is assumed that the InGaN layer having a high In composition is locally formed so that the light emitting wavelength can be elongated. Since the In composition of the quantum well layer can be reduced, the thermodynamic composition variation is prevented, and a thermodynamically stable crystal can be obtained. Thus, a semiconductor device with high reliability can be provided. In addition, since the In composition of the quantum well layer can be reduced, it is possible to increase the thickness of the quantum well layer, and the current density per one quantum well layer can be reduced.

As described above, in the present embodiment, the InAlGaN layer is employed as the barrier layer, thereby elongating the light emitting wavelength without largely reducing the light emitting efficiency. Consequently, it is possible to obtain a green color with high light emitting efficiency, which was conventionally difficult.

Further, in the present embodiment, the intermediate layer 32 is provided between the barrier layer 31 and the quantum well layer 33 and the intermediate layer 34 is provided between the barrier layer 35 and the quantum well layer 33 as shown in FIG. 2. In this manner, an intermediate layer is interposed between the barrier layer and the quantum well layer so that a lattice mismatch between the barrier layer and the quantum well layer can be restricted. Consequently, it is possible to restrict the occurrence of phase separation or defect and to improve the light emitting efficiency of the light emitting layer. This will be described below.

As shown in FIG. 3, the difference in lattice constant between AlN and InN is large. Further, the Al composition of the InAlGaN barrier layer is reasonably high and the In composition of the InGaN quantum well layer is reasonably high. Thus, if the InAlGaN barrier layer and the InGaN quantum well layer are stacked without the intermediate layer, AlN of the barrier layer and InN of the quantum well layer are easily brought into direct contact. Consequently, a drastic lattice mismatch occurs and phase separation or crystal defect easily occurs near the interface between the barrier layer and the quantum well layer. In the present embodiment, the InGaN intermediate layer having a low In composition is interposed between the barrier layer and the quantum well layer as long as it does not affect the band structure. In other words, in the InGaN intermediate layer, the Ga composition is much higher than the In composition and GaN is dominant. As can be seen from FIG. 3, GaN has an intermediate lattice constant between the AlN lattice constant and the InN lattice constant. Therefore, the InGaN intermediate layer is interposed between the InAlGaN barrier layer and the InGaN quantum well layer, thereby restricting the drastic lattice mismatch between the barrier layer and the quantum well layer. As a result, the occurrence of phase separation or defect can be restricted, thereby improving the light emitting efficiency.

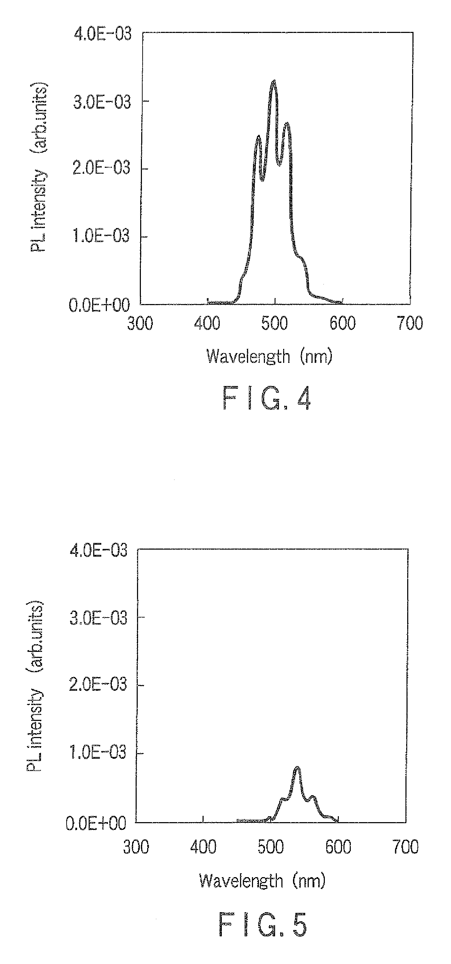

FIG. 4 is a diagram showing a measurement result of the semiconductor device (light emitting diode) according to the present embodiment. Specifically, the figure shows the measurement result by micro photoluminescence (PL). As shown in FIG. 4, a green light emitting spectrum with a very strong light emitting intensity, whose center wavelength is 495 nm, is obtained.

FIG. 5 is a diagram showing a measurement result of a semiconductor device (light emitting diode) according to a first comparative example of the present embodiment. In the first comparative example, the In composition of the quantum well layer is as high as 0.35 for making the barrier layer of InGaN and for elongating the light emitting wavelength. The light emitting intensity is more largely lowered in the comparative example than in the present embodiment. In the comparative example, it is assumed that since the In composition of the quantum well layer is high for achieving an elongated wavelength, the light emitting efficiency is largely lowered from the aforementioned reasons.

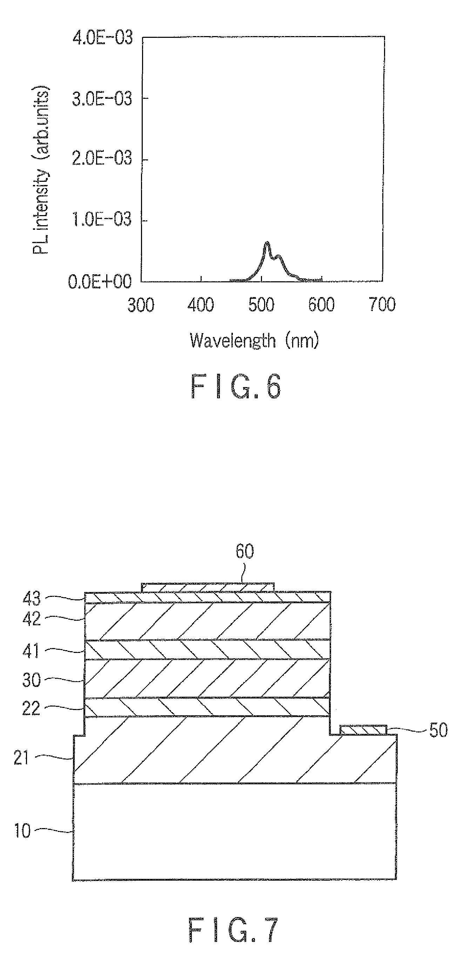

FIG. 6 is a diagram showing a measurement result of a semiconductor device (light emitting diode) according to a second comparative example of the present embodiment. In the second comparative example, the barrier layer and the quantum well layer are stacked without providing the intermediate layer. The light emitting intensity is more largely lowered in the comparative example than in the present embodiment. In the comparative example, it is assumed that since the barrier layer and the quantum well layer are directly stacked without the intermediate layer, the light emitting efficiency is largely lowered from the aforementioned reasons.

Generally, the Al composition of the barrier layer is preferably in the range of 0.2 to 0.4 and the In composition of the barrier layer is preferably in the range of 0.01 to 0.05. The thickness of the barrier layer is preferably in the range of 4 to 20 nm. Further, the intermediate layer preferably has an In composition equal to or higher than that of the barrier layer. Particularly, the In composition of the intermediate layer is preferably in the range of 0.01 to 0.05 similarly as the In composition of the barrier layer. In this manner, the drastic lattice mismatch can be restricted, thereby effectively restricting the occurrence of phase separation or defect. The In composition of the quantum well layer is preferably in the range of 0.1 to 0.3. This is because when the In composition of the quantum well layer is set to be higher than 0.3, an influence of the piezoelectric field is noticeable and the light emitting efficiency can be largely lowered. It is preferable to set the In composition of the quantum well layer at 0.3 or less and to adjust the Al composition of the barrier layer for controlling the light emitting wavelength. Furthermore, the thickness of the intermediate layer is preferably in the range of 0.5 to 1.5 nm.

### (Second embodiment)

Next, a second embodiment according to the present invention will be described. A basic structure thereof is similar as in the first embodiment, and the description of the concerns described in the first embodiment will be omitted.

FIG. 7 is a cross sectional view schematically showing a structure of the semiconductor device (light emitting diode) according to the present embodiment.

A sapphire substrate is employed for the substrate 10, and the upper surface (device forming surface) of the sapphire substrate 10 is the (0001) surface of sapphire crystal, that is, the C surface. An n-type GaN contact layer 21, an n-type GaN guide layer 22, the light emitting layer 30 having a multi quantum well structure, a p-type AlGaN overflow preventing layer 41, a p-type GaN layer 42 and a p-type GaN contact layer 43 are stacked on the upper surface (C surface) of the sapphire substrate 10. Further, an n-side electrode 50 made of Ti/Pt/Au is formed on the exposed surface of the n-type GaN contact layer 21. Furthermore, a p-side electrode 60 made of Ni/Au is formed on the surface of the p-type GaN contact layer 43. The structure of the light emitting layer 30 is similar to the structure explained in the first embodiment.

The overflow preventing layer is effective in the high power light emitting diode having the current density of, for example, about 100 A/cm² or more. As the overflow preventing layer, a layer having the composition of p-InᵤAlᵥGa₁₋ᵤ₋ᵥN (0=<u<1, 0<v<1) can be used in addition to the above example. In this case, it is preferable that the overflow preventing layer has the Al composition higher than that of the barrier layer.

Also in the present embodiment, since the structure of the light emitting layer 30 is similar as the structure explained in the first embodiment, similar effects as those explained in the first embodiment can be obtained.

In the following, a method for manufacturing the semiconductor device (light emitting diode) according to the present embodiment will be described.

Each layer of the present semiconductor device is formed by the metal organic chemical vapor deposition (MOCVD) method. The materials therefor may employ trimethyl gallium (TMG), trimethyl aluminum (TMA), trimethyl indium (TMI) and bis (cyclopentadienyl) magnesium) (Cp2Mg). The gas material may employ ammonia (NH₃) and silane (SiH₄). The carrier gas may employ hydrogen and nitrogen.

At first, the sapphire substrate processed by organic cleaning and acid cleansing is introduced into a reaction chamber of the MOCVD apparatus and is put on a susceptor to be heated by high frequency.

Subsequently, the sapphire substrate is raised in its temperature to 1100°C for 12 minutes under a nitrogen/hydrogen atmosphere at a normal pressure. In the temperature rising process, gas phase etching is performed on the substrate surface to remove a native oxide film on the substrate surface.

Next, nitrogen/hydrogen is employed as a carrier gas to supply ammonia at a flow rate of 6 L/minute, TMG at a flow rate of 50 cc/minute and SiH₄ at a flow rate of 10 cc/minute, for 60 minutes, thereby forming the n-type GaN contact layer 21. Subsequently, the temperature is lowered to 1060°C and SiH₄ is lowered in its flow rate to 3 cc/minute, thereby forming the n-type GaN guide layer 22 for about 3 minutes.

Next, the supply of TMG and SiH₄ is stopped to lower the substrate temperature to 800°C. The carrier gas is switched to only nitrogen, and ammonia and TMG are supplied at a flow rate of 12 L/minute and at a flow rate of 3 cc/minute, respectively. After TMI and SiH₄ are supplied therein at a flow rate of 5 cc/minute and at a flow rate of 1 cc/minute, respectively, for two minutes, TMA is further added at a flow rate of 16 cc/minute and supplied for 12 minutes. Thereafter, the supply of TMA is stopped and the growth is performed for two minutes with TMG and SiH₄ being supplied. Thereafter, the amount of supply of TMI is increased to 80 cc/minute and the growth is performed for 40 seconds. A series of processings is repeated five times, and TMG and TMI are finally supplied at a flow rate of 3 cc/minute and at a flow rate of 5 cc/minute, respectively, for about 14 minutes, thereby forming the light emitting layer 30 having a multi quantum well structure. The processing may not be repeated five times in the same structure. The flow rate of TMG, TMA or TMI may be varied, and the Al composition and In composition may be inclined in the barrier layer 31 and the intermediate layer 32. The cycle of the multi quantum well structure is not limited to 5. It can be selected in the range of 2 to 10.

Next, the supply of TMG and TMI is stopped to raise the temperature to 1030°C with nitrogen and ammonia being supplied. The flow rate of ammonia is switched to 4 L/minute under the nitrogen/hydrogen atmosphere while the temperature is being held at 1030°C. TMG, TMA and Cp₂Mg are supplied therein at a flow rate of 25 cc/minute, a flow rate of about 30 cc/minute and a flow rate of 6 cc/minute, respectively, for one minute to form the p-type AlGaN overflow preventing layer 41. The Al composition of p-type AlGaN is 0.2 or more. It is preferable that the Al composition of p-type AlGaN is higher than the Al composition of the InAlGaN barrier layer 31. This prevents the overflow of electron, and it is preferable for the semiconductor device which is used at high current density.

Then, the supply of only TMA is stopped from the above state to switch the flow rate of Cp₂Mg to 8 cc/minute for supply for about 6 minutes, thereby forming the p-type GaN layer 42.

Then, Cp₂Mg is supplied at a flow rate of 50 cc/minute for about three minutes from the above state, thereby forming the p-type GaN contact layer 43. Subsequently, the supply of organic metal material is stopped and only the carrier gas is continuously supplied so that the substrate temperature naturally decreases. The supply of ammonia stops when the substrate temperature reaches 500°C.

Next, part of the multilayered structure obtained in the above manner is removed by dry etching until it reaches the n-type GaN contact layer 21, and the n-side electrode 50 made of Ti/Pt/Au is formed on the exposed contact layer 21. Further, the p-side electrode 60 made of Ni/Au is formed on the p-type GaN contact layer 43.

Then, when the I-V characteristic is measured on the semiconductor device (light emitting diode) having the structure obtained in the above manner, an excellent characteristic can be obtained. The operating voltage of the light emitting diode is 3.5 to 4 V at 20 mA and the light output is 10 mW. A peak with wavelength center of 500 nm is obtained from the wavelength measurement.

The sapphire substrate was employed as the substrate in the first and second embodiments described above, but a GaN substrate, SiC substrate, ZnO substrate or the like may be employed. Further, the device forming surface is not limited to the C surface and each layer may be formed on a nonpolar surface. It is possible to apply a structure in which an electrode is provided on the backside of the wafer. Furthermore, it is possible to obtain a blue light emitting diode with high light emitting efficiency, in addition to a green light emitting diode with high light emitting efficiency.

## Claims

1. A semiconductor device **characterized by** comprising:
an underlying layer; and
a light emitting layer which is formed on the underlying layer and in which a barrier layer made of InAlGaN and a quantum well layer made of InGaN are alternately stacked.

2. The semiconductor device according to claim 1, **characterized in that** the barrier layer has an In composition lower than that of the quantum well layer.

3. The semiconductor device according to claim 2, **characterized by** further comprising an intermediate layer provided between the barrier layer and the quantum well layer adjacent to each other, made of InGaN and having an In composition lower than that of the quantum well layer.

4. The semiconductor device according to claim 3, **characterized by** further comprising an overflow preventing layer formed on the light emitting layer and having an Al composition higher than that of the barrier layer.

5. The semiconductor device according to claim 3, **characterized by** further comprising a p-InᵤAlᵥGa₁₋ᵤ₋ᵥN (0=<u<1, 0<v<1) layer formed on the light emitting layer.

6. The semiconductor device according to claim 2, **characterized in that** the underlying layer is made of GaN.

7. The semiconductor device according to claim 6, **characterized in that** the underlying layer is substantially formed on (0001) surface of a substrate.
